(19) Europäisches Patentamt
European Patent Office
Office européen des brevets

(11) EP 1 608 062 A1

(12) **EUROPÄISCHE PATENTANMELDUNG**

(43) Veröffentlichungstag:
21.12.2005 Patentblatt 2005/51

(51) Int Cl.⁷: $H03G\ 3/00$, $H03H\ 11/24$

(21) Anmeldenummer: 04102699.8

(22) Anmeldetag: 14.06.2004

(84) Benannte Vertragsstaaten:
AT BE BG CH CY CZ DE DK EE ES FI FR GB GR HU IE IT LI LU MC NL PL PT RO SE SI SK TR
Benannte Erstreckungsstaaten:
AL HR LT LV MK

(71) Anmelder: Siemens Building Technologies AG
8008 Zürich (CH)

(72) Erfinder: Furrer, Adrian
6319, Allenwinden (CH)

(74) Vertreter: Berg, Peter et al
Siemens AG
Postfach 22 16 34
80506 München (DE)

(54) **Digital steuerbarer Widerstand**

(57) Ein zwischen zwei Klemmen (K0 und K1) wirksamer elektrischen Widerstand hat einen Wert, der durch ein digitales Datensignal (D) steuerbar ist. Der besagte digital steuerbare Widerstand umfasst einen Digital-Analog-Wandler (1) und eine spannungsgesteuerte Stromquelle (6), die einen Steuereingang (7) aufweist, der mit dem Spannungsausgang (4) des Digital-Analog-Wandlers (1) verbunden ist. Eine über den Klemmen (K0 und K1) liegende Spannung ist auf einen Referenzeingang (3) des Digital-Analog-Wandlers (1) geführt. Der digital steuerbare Widerstand ist beispielsweise zur Emulierung eines Widerstandsfühlers geeignet.

FIG 1

EP 1 608 062 A1

**Beschreibung**

Die Erfindung bezieht sich auf eine Schaltungsanordnung gemäss dem Oberbegriff des Anspruchs 1.

Die Erfindung bezieht sich auf eine Schaltungsanordnung gemäss dem Oberbegriff des Anspruchs 1. Solche Schaltungsanordnungen eignen sich beispielsweise zur Nachbildung von veränderbaren ohmschen Widerständen oder Potentiometem, beispielsweise zum Nachbilden von abgleichbaren Widerständen in elektronischen Schaltungen. Beispielhaft ist auch ein Widerstands-Temperaturfühler - also beispielsweise ein standardisierter Nickel- oder Platinfühler - durch eine derartige Schaltungsanordnung emulierbar, wobei eine Steuergrösse zum Einstellen eines gewünschten Widerstandswertes als digitaler Wert generiert und als digitales Signal über elektrische Leitungen oder drahtlos an die Schaltungsanordnung übermittelt wird.

Aus DE 199 46 396 A ist eine Schaltungsanordnung dieser Art bekannt, bei dem ein digitalisiertes Signal eines ohmschen Fühlerwiderstands drahtlos übertragen und in einem Empfänger zur Steuerung eines digitalen Potentiometers benutzt wird, durch welches der Fühlerwiderstand nachgebildet wird.

Digital steuerbare Widerstände sind beispielsweise aus US 5 243 535, US 2003/0011464A oder US 6 320 451 bekannt.

Bekannte digital steuerbare Widerstände haben den Nachteil, dass ihr Gesamtwiderstandswert und eine steuerbare Widerstandsveränderung von zahlreichen zusammenschaltbaren Einzelwiderständen abhängig ist. Eine gute Auflösung ist also praktisch nur mittels integrierter Schaltung erreichbar. Spezielle Anforderungen, wie etwa ein bestimmter Maximalwiderstand kombiniert mit einer hohen Auflösung und einer bestimmten maximal zulässigen Eigenerwärmung, sind mit kostengünstigen und marktüblichen Standardbausteinen nicht erreichbar.

Der Erfindung liegt die Aufgabe zu Grunde, eine Schaltungsanordnung für einen digital steuerbaren Widerstand vorzuschlagen, welche die oben geschilderten Nachteile nicht aufweist.

Die genannte Aufgabe wird erfindungsgemäss durch die Merkmale des Anspruchs 1 gelöst. Vorteilhafte Ausgestaltungen ergeben sich aus den abhängigen Ansprüchen.

Nachfolgend werden Ausführungsbeispiele der Erfindung anhand der Zeichnung näher erläutert.

Es zeigen:

Fig. 1 ein Blockschaltbild mit einem digital steuerbaren Widerstand gemäss der Erfindung,
Fig. 2 eine Variante des digital steuerbaren Widerstands, und
Fig. 3 eine weitere Variante des digital steuerbaren Widerstands.

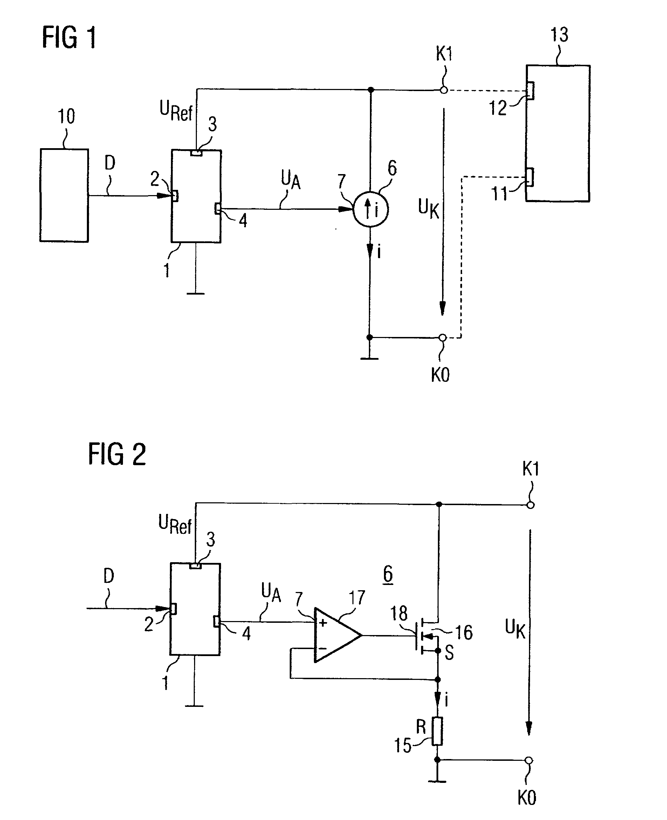

In der Fig. 1 bezeichnet 1 einen Digital-Analog-Wandler, der einen Dateneingang 2 für ein digitales Datensignal D, einen Referenzeingang 3 für eine Referenzspannung $U_{Ref}$ und einen Spannungsausgang 4 für ein elektrisches Analogsignal $U_A$ aufweist.

Eine spannungsgesteuerte Stromquelle 6 ist zwischen eine erste Klemme K0 und eine zweite Klemme K1 geschaltet. Die Stromquelle 6 weist einen Steuereingang 7 auf, auf den der Spannungsausgang 4 des Digital-Analog-Wandlers 1 geführt ist. Das Spannungspotenzial der mit der Stromquelle 6 verbundenen zweiten Klemme K1 ist auf den Referenzeingang 3 des Digital-Analog-Wandlers 1 geführt.

Das dem Digital-Analog-Wandler 1 zugeführte digitale Datensignal D stammt von einer Datenquelle 10, welche beispielhaft ein digitaler Ausgang eines Sensors, ein Knoten eines Datenkommunikationsnetzes oder ein Empfänger eines drahtlos übertragenen Datensignals ist.

Das die spannungsgesteuerte Stromquelle 6 steuernde elektrische Analogsignal $U_A$ ist von der Referenzspannung $U_{Ref}$ und dem digitalen Datensignal D abhängig. Ein zwischen den beiden Klemmen K0 und K1 fliessender Strom i oder ein zwischen den beiden Klemmen K0 und K1 wirkender Widerstand $R_V$ ist damit über das Datensignal D steuerbar. Der zwischen den beiden Klemmen K0 und K1 wirkende digital steuerbare Widerstand $R_V$ ist also grundsätzlich mit der über den Digital-Analog-Wandler 1 gesteuerten Stromquelle 6 implementierbar.

In einer beispielhaften Anwendung des digital steuerbaren Widerstands $R_V$ sind die beiden Klemmen K0 und K1 mit für Widerstandsfühler vorgesehenen Eingangsklemmen 11 und 12 eines Steuer- und/oder Regelgeräts 13 verbunden.

Grundsätzlich ist die gesteuerte Stromquelle 6 je nach erforderlicher Qualität des digital steuerbaren Widerstands Rv mit Hilfe eines bipolaren Transistors, eines Feldeffekt-Transistors oder auch eines Operationsverstärkers realisierbar.

In einem besonders vorteilhaften Ausführungsbeispiel des digital steuerbaren Widerstands $R_v$ weist die spannungsgesteuerte Stromquelle 6 eine zwischen den beiden Klemmen K0 und K1 geschaltete Reihenschaltung mit einem einen Wert R aufweisenden ohmschen Widerstand 15 und einem Feldeffekt-Transistor 16 auf. Der Feldeffekt-Transistor 16 ist hier ein N-Kanal Anreicherungstyp, beispielhaft ein BSS138 der Firma Fairchild, wobei der ohmschen Widerstand 15 mit der ersten Klemme K0 und der Drain-Anschluss des Feldeffekt-Transistors 16 mit der zweiten Klemme K1 verbunden sind. Der mit einem Ende des ohmschen Widerstands 15 verbundene Source-Anschluss S des Feldeffekt-Transistors 16 ist mit einem invertierenden Eingang eines Operationsverstärkers 17 verbunden, während der nicht-invertierende Eingang des Operationsverstärkers 17 der mit dem Spannungsausgang 4 des Digital-Analog-Wandlers 1 verbundene Steuereingang 7 der spannungsgesteuerten Stromquelle 6 ist. Ausgangsseitig ist der Operationsverstärkers 17 mit einem Gate-Eingang 18 des Feldeffekt-Transistors 16 verbunden.

Mit der Annahme, dass der Operationsverstärker 17 als idealer Operationsverstärker wirkt, gelten folgende Gleichungen:

Mit einer zwischen den beiden Klemmen K0 und K1 liegenden Klemmenspannung $U_K$ gelten für einen in der mit dem Feldeffekt-Transistor 16 und dem ohmschen Widerstand 15 gebildeten Reihenschaltung filiessenden Strom i:

$$i = U_A / R$$

und

$$i = U_K / R_V$$

$$\text{und daraus } Rv = (U_K / U_A) \bullet R \qquad \{\text{Gleichung 1}\}$$

Mit einer Auflösung A des Digital-Analog-Wandlers 1 und einem - beispielhaft den Wertebereich 1 bis A aufweisenden - digitalen Signal D ergibt sich der Wert des elektrische Analogsignal $U_A$ des Analog-Digital-Wandlers 1 mit:

$$U_A = U_{Ref} \bullet (D / A) \qquad \{\text{Gleichung 2}\}$$

Mit der Gleichsetzung $U_{Ref} = U_K$ ergibt sich aus den Gleichungen 1 und 2 eine Formel für den zwischen den beiden Klemmen K0 und K1 wirksamen über das digitale Datensignal D digital steuerbaren Widerstand Rv:

$$R_V = R \bullet (A / D) \qquad \{\text{Gleichung 3}\}$$

Die in der Fig. 2 dargestellte Implementierung der spannungsgesteuerten Stromquelle 6 ist eine hohe Qualität der Charakteristik des steuerbaren Widerstandes Rv erreichbar, da eine auf die Einrichtung wirkende, den Strom i beeinflussende Störgrösse ausregelbar ist, da die über dem ohmschen Widerstand 15 liegende Spannung auf den invertierenden Eingang des Operationsverstärkers 17 zurückgeführt ist.

Der Wert R des ohmschen Widerstands 15 bestimmt den minimal erreichbaren Wert des steuerbaren Widerstands $R_V$, was auch aus der Gleichung 3 hervorgeht. Zur Nachbildung eines standardisierten Nickel-Temperaturfühlers ist beispielsweise ein ohmscher Widerstand 15 mit einem Nennwert von etwa 500 Ohm einsetzbar.

Auf dem Markt werden Bausteine — wie beispielsweise der Typ DAC8501 - angeboten, welche einen integrierten Digital-Analog-Wandler zusammen mit einem in der vorgeschlagenen Stromquelle einsetzbaren Operationsverstärker aufweisen.

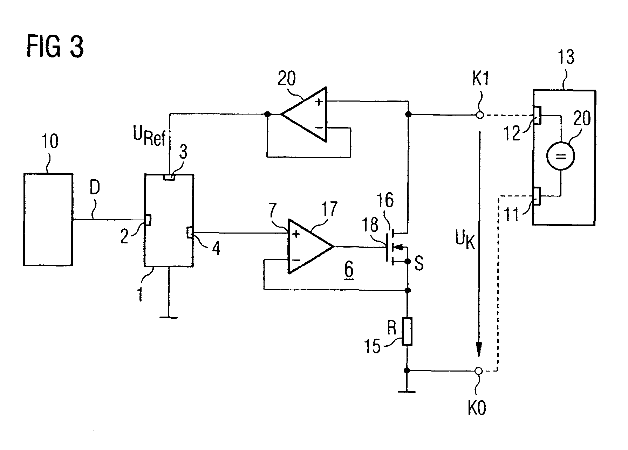

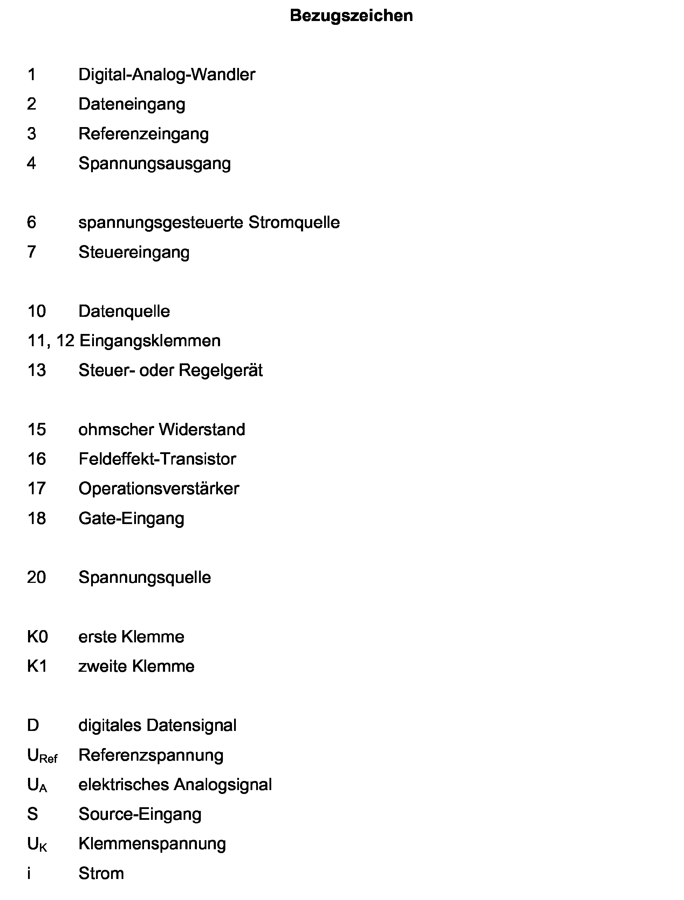

Bei Bedarf - das heisst, wenn der Referenzeingang 3 des eingesetzten Digital-Analog-Wandlers 3 zu niederohmig ist - wird das Spannungspotenzial $U_K$ der zweiten Klemme K1 über einen Spannungsfolger 20 an den Referenzeingang 3 des Digital-Analog-Wandlers 1 geführt (Fig. 3).

In einer vorteilhaften Variante der Erfindung ist die spannungsgesteuerte Stromquelle 6 durch eine externe Spannungsquelle 20 gespeist, die beispielhaft in dem an den beiden Klemmen K0 und K1 angeschlossenen Steuer- und/oder Regelgerät 13 angeordnet ist.

Bei einer Nachbildung oder Emulation eines Widerstandsfühlers durch eine erfindungsgemässe Schaltungsanordnung, ist das an der Datenquelle 10 verfügbare digitale Signal D bei Bedarf - beispielsweise durch ein digitales Filter - derart transformierbar, dass beispielsweise Fehler oder Störungen eliminiert werden.

**Patentansprüche**

**1.** Schaltungsanordnung mit einem zwischen einer ersten Klemme (K0) und einer zweiten Klemme (K1) wirksamen elektrischen Widerstand ($R_V$), dessen Wert durch ein digitales Datensignal (D) steuerbar ist, **gekennzeichnet**

**durch**

einen Digital-Analog-Wandler (1) der einen Dateneingang (2) für das digitale Datensignal (D), einen Referenzeingang (3) für eine elektrische Referenzspannung ($U_{Ref}$) und einen Spannungsausgang (4) für ein elektrisches Analogsignal ($U_A$) aufweist,

eine zwischen den beiden Klemmen (K0, K1) angeordnete spannungsgesteuerten Stromquelle (6),

wobei die spannungsgesteuerte Stromquelle (6) einen Steuereingang (7) aufweist, der mit dem Spannungsausgang (4) des Digital-Analog-Wandlers (1) verbunden ist, und

wobei das Spannungspotenzial ($U_K$) der zweiten Klemme (K1) auf den Referenzeingang (3) des Digital-Analog-Wandlers (1) geführt ist.

2.  Schaltungsanordnung nach Anspruch 1, **dadurch gekennzeichnet, dass** das Spannungspotenzial ($U_K$) der zweiten Klemme (K1) über einen Spannungsfolger (20) auf den Referenzeingang (3) des Digital-Analog-Wandlers (1) geführt ist.

3.  Schaltungsanordnung nach einem vorangehenden Anspruch, **dadurch gekennzeichnet, dass** die spannungsgesteuerte Stromquelle (6) durch eine an den beiden Klemmen (K0, K1) liegende Spannungsquelle (20) gespeist ist.

4.  Schaltungsanordnung nach einem vorangehenden Anspruch, **dadurch gekennzeichnet, dass** die spannungsgesteuerte Stromquelle (6) eine Reihenschaltung aus einem mit der ersten Klemme (K0) verbundenen ohmschen Widerstand (15) und einem mit der zweiten Klemme (K1) verbundenen Transistor (16) aufweist.

5.  Schaltungsanordnung nach einem der Ansprüche 1 bis 3, **dadurch gekennzeichnet, dass** die spannungsgesteuerte Stromquelle (6) eine Reihenschaltung aus einem mit der ersten Klemme (K0) verbundenen ohmschen Widerstand (15) und einem mit der zweiten Klemme (K1) verbundenen Feld-Effekt-Transistor (16) aufweist.

6.  Schaltungsanordnung nach Anspruch 5, **dadurch gekennzeichnet, dass** die spannungsgesteuerte Stromquelle (6) einen Operationsverstärker (17) und einen Feld-Effekt-Transistor (16) aufweist, wobei ein nicht invertierender Eingang des Operationsverstärkers (17) der Steuereingang (7) ist, und wobei ein Ausgang des Operationsverstärkers (17) auf einen Gate-Eingang (18) des Feld-Effekt-Transistors (16) geführt ist, und wobei ein Drain-Anschluss des Feld-Effekt-Transistors (16) mit der zweiten Klemme (K1) und ein Source-Anschluss (S) des Feld-Effekt-Transistors (16) zusammen mit einem Substrat-Anschluss des Feld-Effekt-Transistors (16) mit dem ohmschen Widerstand (15) verbunden sind.

## FIG 1

## FIG 2

FIG 3

# Bezugszeichen

1      Digital-Analog-Wandler

2      Dateneingang

3      Referenzeingang

4      Spannungsausgang

6      spannungsgesteuerte Stromquelle

7      Steuereingang

10     Datenquelle

11, 12 Eingangsklemmen

13     Steuer- oder Regelgerät

15     ohmscher Widerstand

16     Feldeffekt-Transistor

17     Operationsverstärker

18     Gate-Eingang

20     Spannungsquelle

K0     erste Klemme

K1     zweite Klemme

D      digitales Datensignal

$U_{Ref}$   Referenzspannung

$U_A$    elektrisches Analogsignal

S      Source-Eingang

$U_K$    Klemmenspannung

i      Strom

**Europäisches**
**Patentamt**

**EUROPÄISCHER RECHERCHENBERICHT**

**Nummer der Anmeldung**

EP 04 10 2699

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 4 013 975 A (KATAOKA KOJI ET AL) 22. März 1977 (1977-03-22) * Spalte 2, Zeile 38 - Spalte 5, Zeile 7; Abbildung 8 * ----- | 1-6 | H03G3/00 H03H11/24 |
| X | US 5 999 052 A (TANG ZHI-LONG) 7. Dezember 1999 (1999-12-07) * Spalte 5, Zeile 18 - Spalte 7, Zeile 44; Abbildung 4 * ----- | 1-6 | |
| X | US 5 519 397 A (CHAPOTOT MICHEL ET AL) 21. Mai 1996 (1996-05-21) * Abbildung 17 * ----- | 1-6 | |

**RECHERCHIERTE SACHGEBIETE (Int.Cl.7)**

H03G
H03H

Der vorliegende Recherchenbericht wurde für alle Patentansprüche erstellt

| Recherchenort | Abschlußdatum der Recherche | Prüfer |
|---|---|---|
| Den Haag | 23. November 2004 | Lecoutre, R |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes
  Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 04 10 2699

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-11-2004

| Im Recherchenbericht angeführtes Patentdokument | Datum der Veröffentlichung | Mitglied(er) der Patentfamilie | Datum der Veröffentlichung |
|---|---|---|---|
| US 4013975 A | 22-03-1977 | JP 1220556 C | 26-07-1984 |
| | | JP 51114047 A | 07-10-1976 |
| | | JP 58046888 B | 19-10-1983 |
| | | JP 1268982 C | 10-06-1985 |
| | | JP 51114048 A | 07-10-1976 |
| | | JP 59046128 B | 10-11-1984 |
| | | AU 1251776 A | 10-03-1977 |
| | | BR 7601801 A | 05-10-1976 |
| | | GB 1514136 A | 14-06-1978 |
| US 5999052 A | 07-12-1999 | KEINE | |
| US 5519397 A | 21-05-1996 | FR 2702044 A1 | 02-09-1994 |
| | | DE 69402350 D1 | 07-05-1997 |
| | | DE 69402350 T2 | 09-10-1997 |
| | | EP 0612982 A1 | 31-08-1994 |
| | | ES 2100637 T3 | 16-06-1997 |

EPO FORM P0461

Für nähere Einzelheiten zu diesem Anhang : siehe Amtsblatt des Europäischen Patentamts, Nr.12/82